# EUROPEAN PATENT APPLICATION

(11) **EP 2 060 576 A1**
(43) Date of publication of application: **20.05.2009**
(21) Application number: 08169165.1
(22) Date of filing: 14.11.2008
(51) Int. Cl.: C07F 1/00, C07F 19/00, C23C 16/00

(54) **Deposition of Metal Films on Diffusion Layers by Atomic Layer Deposition and Organometallic Precursor Complexes Therefor**

(30) Priority: 16.11.2007 US 941157
(71) Applicant: Air Products and Chemicals, Inc., Allentown, PA 18195-1501 (US)
(72) Inventor: Cheng, Hansong, Allentown,, 18106 (US); Garg, Diwakar, Emmaus,, PA 18049 (US); Ordejon, Pablo, 08025, Barcelona (ES); Cobian, Manuel, 08014, Barcelona (ES)
(74) Representative: Muir, Benjamin M. J.

(57) **Abstract**

Organometallic precursor complexes containing a metal and ligands containing electron withdrawing groups are disclosed. The complexes are adapted to undergo exothermic adsorption on a fully passivated diffusion barrier layer and on a metal layer deposited on the diffusion barrier layer and to undergo exothermic reduction on the diffusion barrier layer and the metal layer. The metal is preferably copper. Use of the complexes in atomic layer deposition is also disclosed.

## Description

### BACKGROUND OF THE INVENTION

The present invention relates to a process for depositing metals by atomic layer deposition on a diffusion barrier layer and to organometallic precursor complexes used in the method.

Atomic layer deposition (ALD) technology was first developed three decades ago when it was applied to deposit materials for display devices. It is a self-limiting process. It grows films by sequential deposition of atom layers via surface reactions in a well-controlled fashion on various substrates. Specifically, the process involves two distinct steps for depositing a metal on a surface - adsorption of a metal precursor on the substrate surface without decomposition followed by dissociation of the metal precursor with the help of a reducing gas. These two steps are repeated multiple times to build atom by atom a metal film of the desired thickness. Although ALD is a process that provides slow growth rate, it is increasingly becoming important for growing conformal, ultrathin films because of continued shrinkage in feature size of semiconductor devices.

Many semiconductor devices utilize copper as an interconnect material because of its low resistivity or high conductivity. However, copper is known to diffuse through silicon-based dielectric layer, which is commonly used for making semiconductor devices. To prevent diffusion of copper into the dielectric layer, a thin intermediate layer (or barrier layer) is deposited on the dielectric layer prior to depositing copper. This barrier layer is deposited by chemical vapor deposition (CVD) or physical vapor deposition (PVD) technique on the dielectric layer. It may include a thin layer of transition metal selected from Ti, Ta, W, etc. or transition metal nitride selected from TaN, TiN, and WN. The use of a transition metal including Ti, Ta or W for barrier layer has been shown to be problematic because it reacts with organometallic copper precursors, resulting in undesirable reactions and poor adhesion of copper film on the barrier layer. Likewise, the use of a metal nitride including TaN, TiN and WN has not been very successful because of the presence of free metal on the surface leading to undesirable surface reaction with the organometallic copper precursors and poor adhesion of the copper film on the barrier layer. On the contrary, good adhesion of CVD copper has been obtained by using substantially pure (>95% pure) transition metal nitride barrier layers with (111) preferred crystallographic orientation or a barrier layer which is fully passivated with nitrogen prior to depositing copper, as disclosed in US 20040219369 A1.

The deposition of copper by ALD on a barrier layer or a nitrogen passivated barrier layer presents an interesting challenge. In the case of depositing copper by CVD even on nitrogen passivated barrier layer, organometallic precursors decompose as soon as they arrive on the surface in the presence or absence of a reducing gas. Since ALD is a two-step deposition process, the mechanism for depositing copper by ALD is very different to that of CVD. The precursor is not supposed to decompose as soon as it arrives near the surface. Instead it is supposed to adsorb on the surface. The adsorbed precursor is then reduced in the second step with a reducing agent to deposit copper. If the organometallic precursor decomposes as soon as it arrives on the surface as in the case of CVD, there will not be any atom by atom deposition of copper and copper metal will not be deposited by ALD technique. Consequently, organometallic copper precursors that were developed for depositing copper by CVD cannot be used to deposit copper by ALD. Therefore, the deposition of copper by ALD requires development of a new class of organometallic copper precursors.

As mentioned above, the deposition of a metal by ALD requires the organometallic precursor to adsorb on the surface of the barrier layer without dissociating followed by reduction of the precursor with a reducing gas to deposit metal on the surface. This technique is rather simple and straightforward, but deposition of an adherent layer of copper by ALD has still posed a significant technical challenge. For example, numerous halogenated and non-halogenated organometallic precursors have been tried to deposit copper by ALD on the barrier layer, but these trials were not successful because the precursors (1) were too reactive and dissociated spontaneously on the surface, (2) caused strong adsorption of both copper atom and ligand on the substrate surface, thereby producing copper layer with carbon and/or oxygen impurities, or (3) resulted in providing unacceptable adhesion to the substrate. Halogenated inorganic precursors of copper such as CuClx have also been used to deposit copper by ALD on the barrier layer, but the use of halogenated inorganic precursors resulted in incorporating halogens in the copper film, which eventually failed due to corrosion of both copper film and the barrier layer.

To resolve problems stated above, numerous researchers explored a wide variety of organometallic precursors for depositing copper on the barrier layer. However, they have not been successful in depositing copper by ALD with good adhesion on a barrier layer. They resorted to using another layer at the top of the barrier layer prior to depositing copper. For example, they deposited a layer of another metal such as ruthenium, platinum, gold, etc. on the top of the barrier layer prior to depositing copper by ALD to improve adhesion of the copper layer on the substrate. The use of another layer at the top of the barrier layer presents other problems. It is therefore not desirable to use another metal layer prior to depositing copper.

US 2006134331 discloses a three-step process for depositing copper film on a substrate by ALD. The process involves (1) exposing the substrate surface to a surface-activating agent to form a surface-activating group on the surface, (2) exposing the surface-activating group to a copper precursor to form a copper complex on the surface, and (3) reducing the copper complex with a reducing agent to deposit copper on the substrate. The publication discloses an example for depositing copper on a gold layer. It does not disclose any examples describing that the process can be used to deposit copper adherently on a barrier layer by ALD.

WO 2006015200 describes the preparation of 1,3-diimine and 1,3-diimine copper complexes with the structure shown below and use of them for depositing copper by ALD on a substrate: 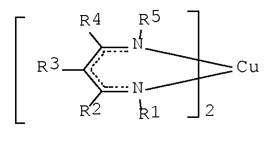 where R1-R5 are independently selected from hydrogen, methyl, ethyl, propyl, isopropyl, isobutyl, and neopentyl, with the proviso that at least one of (R1, R2) and (R4, R5) taken together is -(CR⁶R⁷)ₙ-, where R⁶ and R⁷ are independently selected from hydrogen, fluorine, trifluoromethyl, C1-C5 alkyl, and C1-C5 alkyl ester, and n is 3, 4 or 5. Although the reference describes the use of the above precursor for depositing copper by ALD on barrier layer, it discloses neither examples showing deposition of copper on a barrier layer nor the quality of copper deposited on the barrier layer.

US 2005281952 describes the preparation of copper (I) amidinate compounds having a structure shown below and their use for depositing copper on a substrate by ALD: 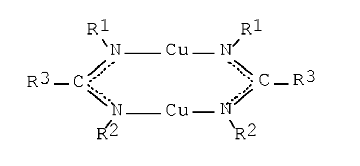 where R1-R3 can be isopropyl (i-Pr) or R1 and R2 are isopropyl and R3 is dimethylamine (NMe₂). Although this reference describes the use of the above precursor for depositing copper by ALD on barrier layer, it discloses neither examples showing deposition of copper on a barrier layer nor the quality of copper deposited on the barrier layer.

US 2004247905 and US 2005227007 describe the preparation of 1,3-diiminato copper (I) complexes, as shown in the figure below: 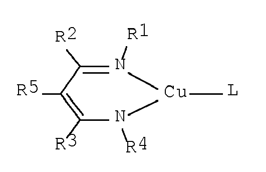 where L can be C1- C15 olefin, C2-C15 alkyne, nitriles, aromatic heterocyclic compounds, phosphines, and R1-R4 are hydrogen, various defined alkyls, and/or fluorine. These references also disclose the use of these complexes for depositing Cu by ALD on a substrate. The process involves contacting a substrate with copper complex followed by exposing adsorbed copper complex to a reducing agent including 9-BBN, diborane, borane, various phenyl- or alkylboranes, dihydrobenzofuran, pyrazoline, disilane, silanes or germanes. For example, vinyltrimethylsilane (N,N'-diisobutyl-2,4-pentanediketiminato) copper (I) was first adsorbed on the tantalum barrier layer. The adsorbed copper organometallic precursor was then reduced by exposing it to diethylsilane to deposit copper. Although these references describe the use of the above precursor for depositing copper by ALD on barrier layer, they disclose neither examples showing deposition of copper on a barrier layer nor the quality of copper deposited on the barrier layer.

US 2004087143 discloses deposition of copper by ALD. A copper halide layer is first deposited on the substrate such as TiN by using a halogen-containing precursor and a copper metal-containing precursor. The metal halide layer is then exposed to a reducing agent such as diethylsilane to deposit copper. The reference fails to disclose the quality of copper adhesion on the barrier layer. Since a halogen containing precursor is known to react with the barrier layer unless the barrier layer is fully passivated with nitrogen, the adhesion of copper on the barrier layer is expected to be poor.

US 2005240028 describes preparation of 2-pyrrolealdeimines (HL) and CuL2 complexes and their use for depositing copper by ALD. The selected copper pyrrolealdemethylimine complex is described to be adsorbed on the substrate first and then exposed to a reducing agent at 100-300° to deposit Cu. Although this reference describes the use of the above precursor for depositing copper by ALD on barrier layer, it discloses neither examples showing deposition of copper on a barrier layer nor the quality of copper deposited on the barrier layer.

US 2005003075 and 2005267305 describe the preparation of 1,3-diimine copper complex and its use for depositing copper by ALD on a substrate. Although these references describe the use of the above precursor for depositing copper by ALD on barrier layer, they disclose neither examples showing deposition of copper on a barrier layer nor the quality of copper deposited on the barrier layer.

Therefore, there has been a need to develop improved organometallic complexes and processes for using them for depositing copper or other metals by ALD adherently and directly on the barrier layer.

### BRIEF SUMMARY OF THE INVENTION

Accordingly, a first aspect of the invention comprises an organometallic precursor complex adapted to undergo exothermic chemisorption on a fully passivated diffusion barrier layer and on a metal layer deposited on the diffusion barrier layer and to undergo exothermic reduction on the diffusion barrier layer and the metal layer, wherein the complex comprises a metal of the metal layer and ligands containing electron withdrawing groups.

Preferably, the organometallic precursor is a complex represented by Formula I: 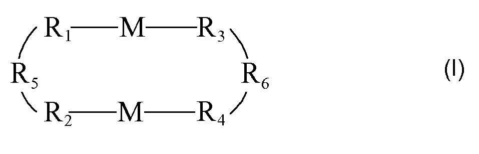 or Formula II: 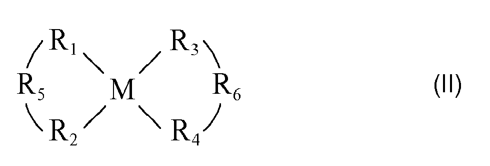 where M is Cu, Co, Ni, Ru, Au, Pd, Ag or Pt, each of R₅ and R₆ independently represents a C1 to C3 hydrocarbon and each of R₁, R₂, R₃ and R₄ independently represents an element selected from N, O, P, B and S, provided that at least one of R₁, R₂, R₃, R₄, R₅ and R₆ is independently substituted with at least one electron withdrawing group.

A second aspect of the invention comprises an organometallic copper complex represented by Formula III: 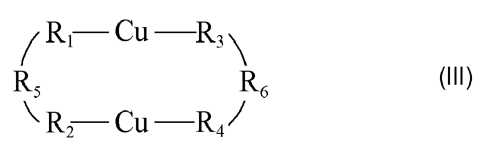 or Formula IV: 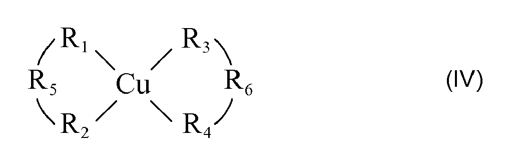 where each of R₅ and R₆ independently represents a C1 to C3 hydrocarbon and each of R₁, R₂, R₃ and R₄ independently represents an element selected from N, O, P, B and S, provided that at least one of R₁, R₂, R₃, R₄, R₅ and R₆ is independently substituted with at least one electron withdrawing group.

Preferably, the complex undergoes exothermic chemisorption on a WN (111) surface and on a copper surface and undergoes exothermic reduction on the WN (111) surface and on the copper surface.

In a preferred embodiment: (a) the complex is sufficiently chemically stable such that the complex does not dissociate prior to being contacted with a reducing agent; (b) the complex has sufficient volatility such that the complex can be delivered in a vapor phase to an atomic layer deposition chamber; and (c) ligands in the complex are non-reactive to a fully passivated barrier layer and a copper layer deposited by the complex onto the barrier layer.

Each of R₅ and R₆ may for example independently be an unbranched alkyl group.

The at least one electron withdrawing group may for example be at least one member selected from -CF₃, -CN, -CHO, -NO₂, -COCF₃, -COF, -Aryl, -CH(CF₃)₂, - C(CF₃)₃ and -SO₂CF₃.

Each of R₅ and R₆ may for example be independently substituted with the at least one electron withdrawing group.

Each of R₁, R₂, R₃, R₄, R₅ and R₆ may for example be independently substituted with the at least one electron withdrawing group.

In one embodiment, the complex is represented by the structure:

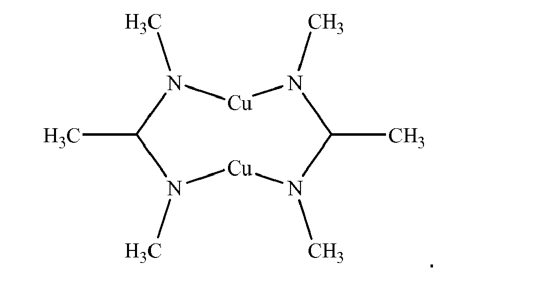

In another embodiment, the complex is represented by the structure:

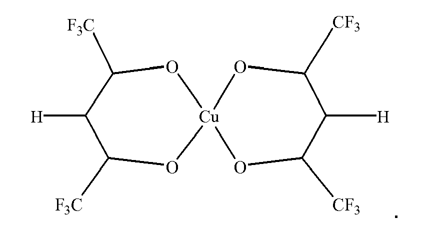

A third aspect of the invention comprises a process for providing a metal layer on a fully passivated diffusion barrier layer, said process comprising: (a) supplying a complex of the first or second aspects; (b) adsorbing the complex on the diffusion barrier layer; and (c) reducing the complex on the diffusion barrier layer to provide the metal layer on the diffusion barrier layer by atomic layer deposition.

The diffusion barrier layer may for example comprise a metal nitride, a metal carbide, a metal carbonitride, a metal silicon nitride, a metal silicon carbide, a metal silicon carbonitride, or a mixture thereof. A preferred the diffusion barrier layer comprises a metal nitride selected from chromium nitride, tantalum nitride, titanium nitride, tungsten nitride, molybdenum nitride, zirconium nitride, vanadium nitride and mixtures thereof.

The adsorbing and reducing steps are preferably exothermic.

The supplying, adsorbing and reducing steps may for example be repeated a plurality of times such that a depth of the metal layer is adjusted.

In one embodiment, the diffusion barrier layer comprises substantially pure tungsten nitride with (111) preferred orientation, the adsorbing step comprises exothermic chemisorption of the complex on the tungsten nitride (111) and on the metal deposited on the tungsten nitride (111), and the reducing step comprises exothermic reduction of the complex on the tungsten nitride (111) and on the metal deposited on the tungsten nitride (111).

In a preferred embodiment: (a) the complex does not dissociate prior to the reducing step; (b) the process is conducted in an atomic layer deposition chamber; (c) the supplying step comprises providing the complex in the atomic layer deposition chamber in a vapor phase; and (d) ligands in the complex do not react with the diffusion barrier layer and/or the metal layer.

A fourth aspect of the invention comprises a substrate comprising a metal layer produced by the process of the third aspect.

### DETAILED DESCRIPTION OF THE INVENTION

Deposition of metal by ALD requires multiple cycles of adsorption of organometallic precursor complexes (also referred to herein as "organometallic precursors", "organometallic complexes" and "complexes") followed by their reduction by a reducing agent. The very first cycle of the ALD process generally involves depositing the metal directly on the barrier layer. Once the barrier layer is covered with the metal, subsequent amounts of metal are deposited on the earlier deposited metal. Therefore, the organometallic precursors must be capable of depositing metal by ALD on the barrier layer and on the nascent metal layer overlying the barrier layer.

The invention is based on the development of organometallic precursors adapted to be: (1) adsorbed on the substrate surface (which as defined herein includes the fully passivated diffusion barrier layer and/or the nascent metal layer overlying the diffusion barrier layer) by a thermochemically exothermic adsorption reaction; and (2) reduced with a reducing agent by a thermochemically exothermic reduction.

In addition, organometallic precursors of the invention preferably possess one or more of the following characteristics:
(a) The organometallic precursor must be chemically stable and must not dissociate (e.g., through a disproportionation reaction) upon being exposed to the substrate surface.
(b) The ligands in the organometallic precursor must be non-reactive to the substrate surface to provide good adhesion of metal to the substrate surface.
(c) The organometallic precursors must have sufficient volatility so that they can be delivered in vapor phase to the ALD chamber.

The structures of the organometallic precursors of the invention preferably enable metal atoms present in the precursor to adsorb on the substrate surface while keeping the ligands away from the substrate surface during the first step or the adsorption step. The structure then allows ligands to break free in the presence of a reducing agent without leaving traces of the ligands on the surface and deposit metal on the substrate surface in the second step. The cyclic deposition process is repeated again, but this time the precursor is adsorbed on the nascent metal layer deposited on the underlying barrier layer.

Preferred organometallic precursors of the invention are represented by Formula I: 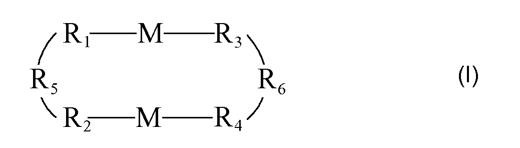 or Formula II: 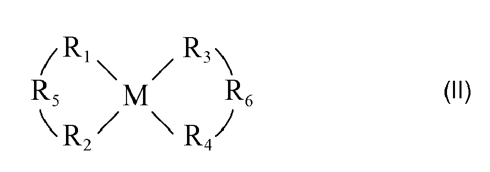 where M is a transition metal, each of R₅ and R₆ independently represents a C1 to C3 hydrocarbon and each of R₁, R₂, R₃ and R₄ independently represents an element selected from N, O, P, B and S, provided that at least one of R₁, R₂, R₃, R₄, R₅ and R₆ is independently substituted with at least one electron withdrawing group. Preferably, all of R₁-R₆ are substituted with at least one electron withdrawing group (which can be the same or different groups).

Electron withdrawing groups are substituents which attract valence electrons from neighboring atoms. A quantification of the level of electron-withdrawing capability is given by the Hammett sigma constant. The Hammett constant values are generally negative for electron donating groups and positive for electron withdrawing groups. Electron withdrawing groups of the invention are more electronegative than hydrogen. Non-limiting examples of suitable electron withdrawing groups include -CF₃, -CN, -CHO, -NO₂, -COCF₃, -COF, -C₆H₅, -SO₂CF₃, -C(CF₃)₃.

Suitable metals for use in the organometallic precursors include but are not limited to transition metals, such as Cu, Co, Ru, Au, Ni, Ag, Pd or Pt, with Cu being most preferred. Thus, while much of what follows focuses on copper complexes and ALD of copper as exemplary embodiments, the invention is not limited to such embodiments.

### Development of New Precursors

Extensive first-principles simulations based on quantum mechanical density functional theory were performed to simulate deposition of copper by ALD on WN (111) and Cu (100) surfaces using a range of organometallic precursors. The simulations included precursors that are currently available in the market and those disclosed for the first time in this patent application. It is important to mention that the surface of barrier layer WN (111) was well passivated with nitrogen, as the top layer of WN (111) was fully covered by nitrogen atoms on which the first layer of Cu is deposited. The subsequent Cu layers were deposited on the top of ALD Cu layer that was already deposited on WN (111) barrier layer.

Although simulations are done with fully nitrogen passivated WN(111) barrier layer, other fully nitrogen passivated barrier layers such as TaN(111) and Ti(111) are expected to behave similarly to WN(111). Furthermore, barrier layers other than WN(111), TaN(111) and TiN(111) will also work as long as the surface of the barrier layer is fully passivated.

The first-principles simulations showed that currently available organometallic precursors were not suitable for depositing copper on WN (111) barrier layer because of strong interaction of both copper atoms and ligands with the barrier layer. This strong interaction makes the reduction step highly endothermic, leading to poor adhesion of the copper layer on the barrier layer. However, the currently available precursors were found to be suitable for depositing copper on copper or other metals with good adhesion. This is likely the reason for researchers to propose and use another metal layer at the top of the barrier layer to deposit copper by ALD.

The first-principles simulations showed that carefully designed organometallic copper precursors could be used for depositing copper directly on the fully nitrogen passivated barrier layer (without using another metal layer at the top of the barrier layer) like WN (111) with good adhesion. These new organometallic precursors provide strong bonding between the copper atoms and the nitrogen atoms present at the top of the WN (111) barrier layer and weak interaction between ligands and the nitrogen atoms, leading to the deposition of copper by ALD directly and adherently on the barrier layer. These precursors also provide strong bonding between the copper atoms and the copper layer that was deposited on the top of the barrier layer and weak interaction between ligands and the ALD copper layer, leading to the deposition of adherent copper on the ALD copper layer. The adsorption of carefully designed organometallic copper precursors and their reduction for depositing copper on the barrier layer by ALD were noted to be thermodynamically favorable.

The ligands present in the organometallic copper precursors preferably exhibit the following characteristics:
(a) The interaction between the ligands of a precursor and the fully passivated diffusion barrier layer (or the copper layer) should be weaker than the interaction between the copper atom in the precursor and the diffusion barrier layer (or copper layer).
(b) The interaction between the ligands of a precursor and the fully passivated diffusion barrier layer (or copper layer) should be sufficiently weak such that the adsorption energy of the ligands would be weaker than or comparable to typical physical adsorption.
(c) The size of the ligands in the precursor should not be large enough to shield the copper atom to be delivered onto the fully passivated diffusion barrier layer (or copper layer).

The first-principles simulations revealed that organometallic copper precursors with (1) ligands containing electron-withdrawing species and (2) properties that expose copper atom to the substrate surface upon interacting with the substrate surface were significant properties that enabled copper atom present in the precursor to be adsorbed on the fully passivated diffusion barrier (or copper layer) with moderate adsorption energy. This moderate adsorption energy made the reduction process thermodynamically favorable for depositing copper on the fully passivated diffusion barrier (or copper layer).

Organometallic metal precursors suitable for use in the invention are preferably synthesized by adaptation of the methods of Li et al., "Synthesis and Characterization of Cu(I) Amidinates as Precursors for Atomic Layer Deposition (ALD) of Copper Metal." Inorganic Chemistry, 2005, 44(6): 1728-1735, and Li et al., "Synthesis and Characterization of Volatile, Thermally Stable, Reactive Transition Metal Amidinates." Inorganic Chemistry, 2003, 42(24): 7951-7958. Thus, metal amidinate compounds are preferably synthesized by metathesis reactions of metal halides with corresponding equivalents of lithium amidinates. Lithium amidinates are preferably prepared by reaction of corresponding carbodiimides and akyllithiums. Lithium amidinates are preferably provided with the desired electron withdrawing groups by substitution (e.g., by direct fluorination), and/or by inclusion of the desired electron withdrawing groups in the carbodiimides and/or akyllithiums.

### Description of Reaction Mechanism

Cu (I) organometallic precursors with structures similar to Formula I as described above were used in the simulation to study deposition of copper by ALD.

Likewise, Cu (II) organometallic precursors with structures similar to Formula II as described above were used in the simulation to study deposition of copper by ALD.

Extensive first-principles simulations unraveled the detailed reaction mechanism involved in depositing copper by ALD on WN (111) and copper surfaces. The reaction mechanism involved in depositing copper on these two surfaces differed considerably, as described below.

### WN (111) Surface

On a nitrogen-passivated transition metal surface such as WN (111), the Cu (I) or Cu (II) precursor is first adsorbed during the adsorption cycle on the surface at the 4-fold hollow site which is formed by 4 N atoms. During the reduction cycle, the adsorbed species is attacked by a reducing gas such as hydrogen at the atoms that are bonded with the Cu atom in the precursor, leading to the dissociation of the hydrogen molecule and the reduction of the Cu atom. As a result, the Cu atom is deposited onto the diffusion barrier layer and the ligands are liberated from the surface into the gas phase. The reactions involved in the entire process of depositing copper with Cu (I) and Cu (II) organometallic precursors are shown below.

### Cu (I) Compound

(a) Adsorption step 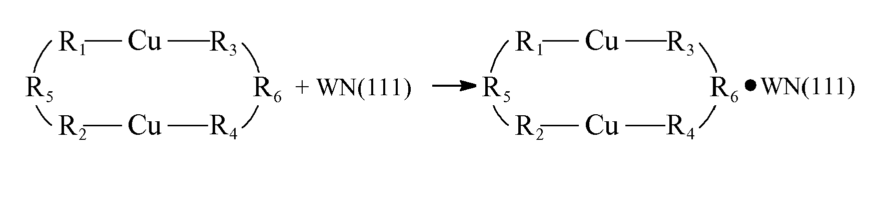
(b) Reduction step

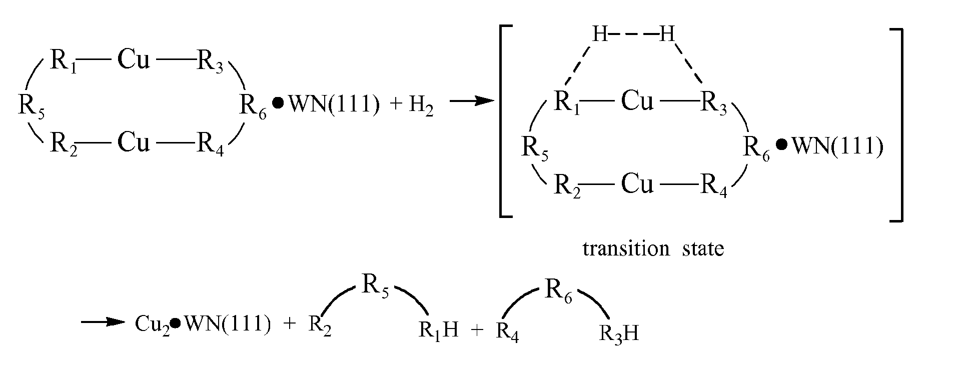

### Cu (II) Compound

(a) Adsorption step 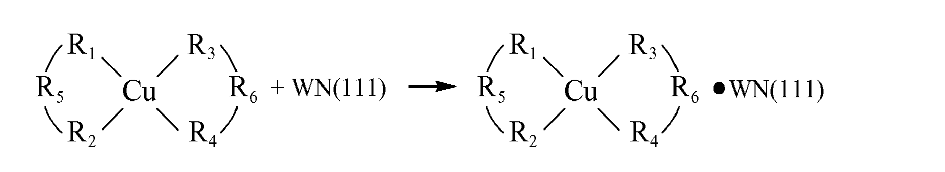
(b) Reduction step

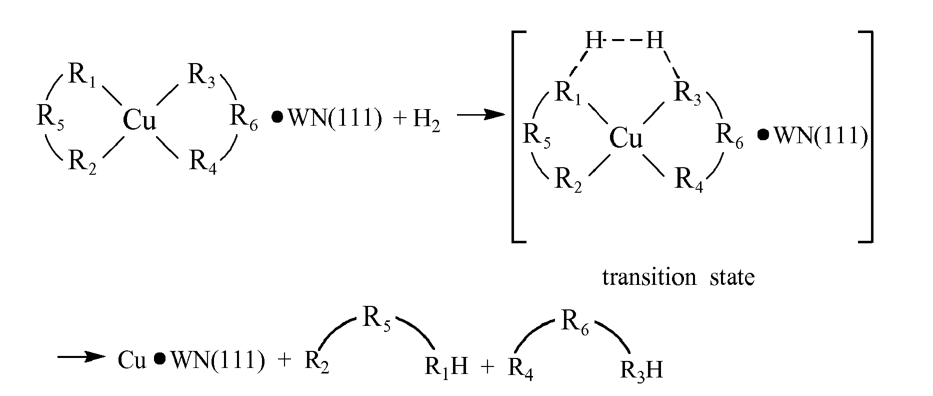

The thermochemical energies for the above reactions are calculated as the energy difference between the products and the reactants. They determine whether the reaction is thermodynamically feasible or not. For example, if the thermochemical energy for a reaction is negative or exothermic, the reaction would be favorable; otherwise the reaction would not occur.

### Copper Surface

On a Cu surface such as ALD deposited copper, the Cu (I) or Cu (II) precursor is first adsorbed during the adsorption cycle on the Cu surface. During the reduction cycle, the hydrogen molecule undergoes dissociative chemisorption on the Cu surface, forming H atoms with high mobility. The atomic hydrogen then attacks the adsorbed species at the atoms that are bonded with the Cu atom in the precursor, leading to the reduction of the Cu atom. As a result, the Cu atom is deposited onto the Cu surface and the ligands are liberated from the surface into the gas phase. The reactions involved in the entire process of depositing copper with Cu (I) and Cu (II) organometallic precursors are shown below.

### Cu (I) compound

(a) Adsorption step 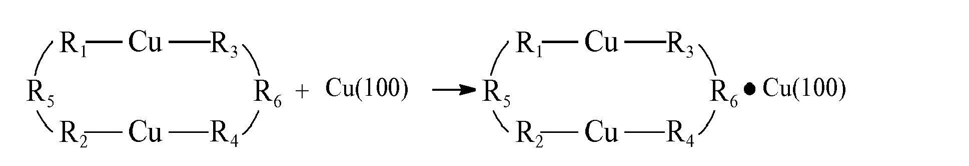
(b) Hydrogen dissociative chemisorption step

   H₂ + Cu(100) → 2H•Cu(100)
(c) Reduction step

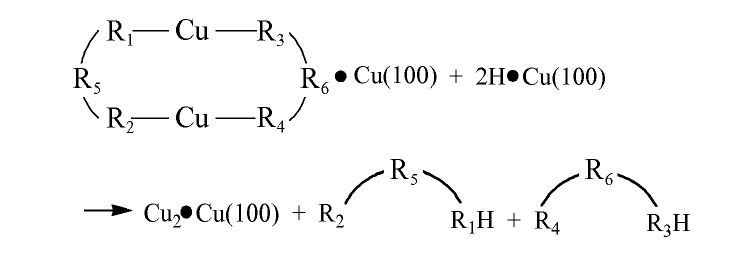

### Cu (II) compound

(a) Adsorption step 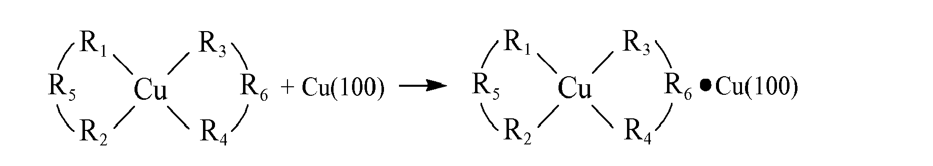
(b) Hydrogen dissociative chemisorption step

   H₂ + Cu(100) → 2H•Cu(100)
(c) Reduction step

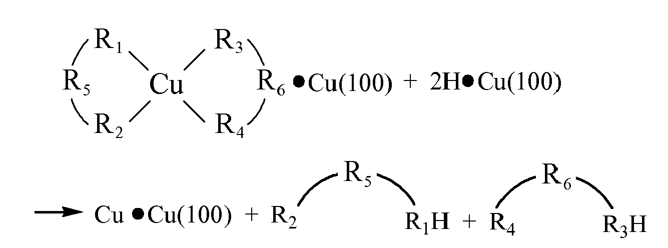

The thermochemical energies for the above reactions are calculated as the energy difference between the products and the reactants. They determine whether the reaction is thermodynamically feasible or not. For example, if the thermochemical energy for a reaction is negative or exothermic, the reaction would be favorable, otherwise the reaction would not occur.

While depositing a metal by ALD, the organometallic precursor is vaporized and introduced into the deposition chamber with the help of an inert carrier gas. The organometallic precursor adsorbs on the surface of the substrate which is placed in the chamber. The substrate surface is predeposited with a fully passivated barrier layer. The organometallic precursor forms a monolayer of metal precursor. The excess precursor is then removed by purging the chamber with an inert gas. After purging the chamber with an inert gas, a reducing gas such as hydrogen, hydrogen activated with plasma, or hydrogen donated by another chemical such as silane, disilane, diethylsilane, etc. is introduced into the chamber along with an inert gas. The reducing gas reduces the adsorbed organometallic precursor, depositing the metal on the barrier layer and removing ligands from the precursor. The ligands are then swept away from the chamber by the inert gas. The chamber is then purged with an inert gas to remove reducing gas from the chamber. This completes one cycle of depositing metal by ALD. This cycle is repeated a number of times to build the desired thickness of metal on the barrier layer.

A number of carrier gases or inert gases can be used during deposition of copper by ALD. They can be selected from gases including but not limited to nitrogen, helium, argon, and mixtures of two or more thereof.

During ALD processing, the substrate is kept at a temperature range that facilitates adsorption of the organometallic precursor over dissociation of the precursor. The process chamber and substrate temperature may range from 25°C to 300°C, preferably from 25°C to 250°C. The pressure in the chamber during the ALD process may range from 0.1 to 1000 Torr (13 to 130000 Pa), preferably from 0.1 to 250 Torr (13 to 33000 Pa), more preferably from 0.1 to 100 Torr (13 to 13000 Pa). It is understood that the temperature and pressure for the ALD process may vary depending upon the types of the organometallic precursor and the reducing agent employed.

Substrates are preferably integrated circuits or any other substrate surface that require deposition of a thin metal layer. The substrate surface is predeposited with a fully passivated diffusion barrier layer (sometimes referred to herein as a "barrier layer") suitable for preventing diffusion of the metal into, and/or interaction of the metal with, the material underlying the barrier layer. The diffusion barrier layer can be comprised of a material such as a metal, a metal carbide, a metal nitride, a metal carbonitride, a metal silicon nitride, a metal silicon carbide, a metal silicon carbonitride, or a mixture thereof. Exemplary metals suitable for use in the barrier layer include titanium, tungsten, chromium, tantalum, molybdenum, zirconium, vanadium, or mixtures thereof. Some exemplary metal carbides include titanium carbide, tungsten carbide, tantalum carbide, chromium carbide, molybdenum carbide, vanadium carbide, zirconium carbide, or mixtures thereof. Exemplary metal nitrides include, but are not limited to, titanium nitride, tungsten nitride, tantalum nitride, chromium nitride, molybdenum nitride, zirconium nitride, vanadium nitride, or mixtures thereof. Exemplary metal carbonitrides include titanium carbonitride (TiCN), tantalum carbonitride (TaCN), chromium carbonitride, tungsten carbonitride, molybdenum carbonitride, zirconium carbonitrides, or mixtures thereof. Exemplary metal silicon nitrides include titanium silicon nitride (TiSiN), molybdenum silicon nitride (MoSiN), etc. Exemplary metal silicon carbides include titanium silicon carbide (TiSiC), tungsten silicon carbide (WSiC), etc. Exemplary metal silicon carbonitrides include silicon carbonitride, titanium silicon carbonitride, and tantalum silicon carbonitride, etc. In certain embodiments, the diffusion barrier layer is preferably a substantially pure (>95% pure) transition metal nitride barrier layer with (111) preferred crystallographic orientation.

The barrier layer comprising the above mentioned metals, metal nitrides, metal carbides, etc., is fully passivated with nitrogen, a nitrogen containing compound, a carbon containing compound, and/or a nitrogen and carbon containing compound prior to depositing metal by ALD. For example, a barrier layer comprising metals including titanium, tungsten, chromium, tantalum, molybdenum, zirconium, vanadium, or mixtures thereof is fully passivated with nitrogen, a nitrogen containing compound, a carbon containing compound, and/or a nitrogen and carbon containing compound prior to depositing metal by ALD. The passivation techniques may include thermal or plasma passivation in the presence of nitrogen, nitrogen containing, carbon containing, and/or nitrogen and carbon containing gases. Suitable nitrogen and carbon containing gases include ammonia and methane.

A wide variety of reducing agents can be used for reducing adsorbed organometallic precursor and depositing metal. They can be selected from agents including but not limited to hydrogen, remotely activated hydrogen, hydrogen atoms, plasma activated hydrogen and compounds capable of donating hydrogen such as silane, disilane, borane, diborane, etc.

### EXAMPLES

The invention will be illustrated in more detail with reference to the following Examples, but it should be understood that the present invention is not deemed to be limited thereto.

Extensive first principles calculations based on density functional theory were carried out to study deposition of copper by ALD using known organometallic copper compounds and a new class of organometallic compounds on tungsten nitride diffusion barrier layer and copper layer. The organometallic compounds studied and developed are sufficiently volatile so that they can be delivered easily by conventional means to the ALD chamber.

### Examples Describing Deposition of Copper with Cu (I) Compounds

### Comparative Example 1

The first principles calculations were performed for the Cu (I) precursor with structure A shown below. The structure consists of an 8-membered ring with 4 methyl groups bonded with the N atoms at 4 corners.

### Structure A

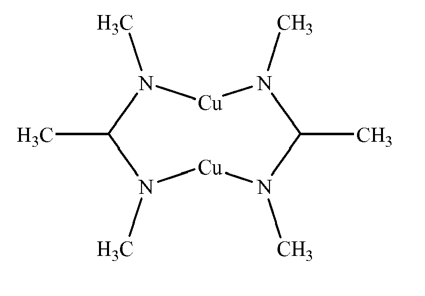

This compound has been used by researchers to deposit copper by CVD on a metal layer deposited at the top of the barrier layer.

The calculations show that this molecule undergoes strong chemisorption on the surface of tungsten nitride barrier layer with (111) preferred orientation, i.e. WN (111). The adsorption energy is calculated to be -3.96eV, which is highly exothermic. The energy required for reducing the adsorbed copper compound is calculated to be 3.23eV, which is highly endothermic. Since the reduction step is endothermic, it is not possible to use this copper precursor to deposit copper by ALD on WN (111) surface.

The calculations also show that this compound undergoes strong chemisorption on Cu (100) surface with an adsorption energy of -2.39eV. The energy required for reducing the adsorbed copper compound is calculated to be -2.87eV. Since the reduction step is exothermic instead of endothermic, this compound can be used to deposit copper on copper by ALD.

Since the copper ALD process requires depositing copper first on the barrier layer then on the copper layer that is already deposited on the barrier layer, this organometallic copper compound is not suitable for depositing copper by ALD on a barrier layer.

### Comparative Example 2

The first principles calculations were performed for the Cu (I) precursor with structure B shown below. The structure consists of an 8-membered ring with 4 isopropyl groups bonded with the N atoms at 4 corners.

### Structure B

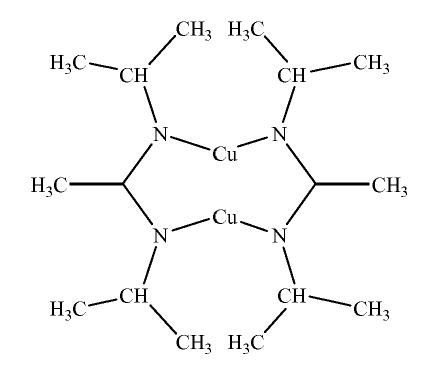

This compound was synthesized by Li et al., supra, for depositing copper by ALD. Although these papers talk about depositing copper by using this compound, no information has been disclosed about the type of substrate or the quality of adhesion of the copper layer on the substrate.

The calculations show that this molecule undergoes strong chemisorption on the surface of tungsten nitride barrier layer with (111) preferred orientation, i.e. WN (111). The adsorption energy is calculated to be -3.75eV. The energy required for reducing the adsorbed copper complex is 2.74eV, which is endothermic. Therefore, this copper precursor is not suitable for depositing copper by ALD on WN (111) surface.

The calculations show that this compound undergoes strong chemisorption on Cu (100) surface with adsorption energy of -2.01eV. The energy required for reducing the adsorbed copper complex is -2.75eV. Therefore, this compound can be used to deposit copper on copper by ALD.

Since the whole copper ALD process requires depositing copper first on the barrier layer then depositing copper on copper that is already deposited on the barrier layer, this organometallic copper compound is not suitable for depositing copper by ALD on a barrier layer.

### Example 3

The first principles calculations were performed for a Cu (I) precursor with structure C shown below. The structure consists of a substituted 8-membered ring with 10 trifluoromethyl groups dispersed about the structure.

### Structure C

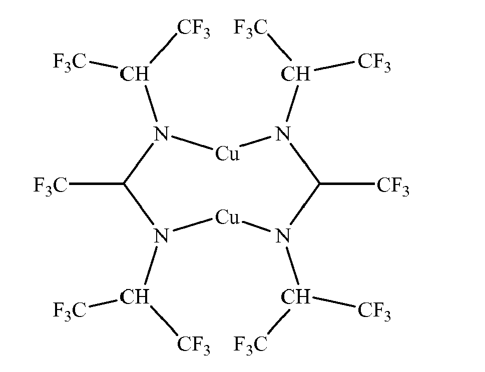

This is a new compound that has not been used by anyone for depositing copper either by CVD or ALD. The calculations show that this molecule undergoes chemisorption on the surface of tungsten nitride barrier layer with (111) preferred orientation, i.e. WN (111). The adsorption energy is calculated to be -0.44eV. The energy required for reducing the adsorbed copper complex is -0.73eV. Therefore, this copper precursor is suitable for depositing copper by ALD on WN (111) surface.

The calculations show that this molecule also undergoes strong chemisorption on the Cu (100) surface with adsorption energy of -2.31eV. The energy required for reducing the adsorbed copper complex is -2.59eV. Therefore, this copper precursor is suitable for depositing copper by ALD on Cu (100) surface.

Since the whole copper ALD process requires depositing copper first on the barrier layer then depositing copper on copper that is already deposited on the barrier layer, this organometallic copper compound is suitable for depositing copper by ALD on a barrier layer.

### Examples Describing Deposition of Copper with Cu (II) Compounds

### Comparative Example 4

The first principles calculations were performed for Cu (II) precursor with structure D shown below. The structure consists of 2 6-membered rings with 4 oxygen atoms chelating the Cu atom.

### Structure D

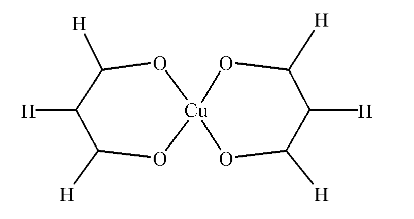

The calculations show that this molecule undergoes strong chemisorption on the surface of tungsten nitride barrier layer with (111) preferred orientation, i.e. WN (111). The adsorption energy is calculated to be -3.63eV. Besides the Cu atom, the carbon atoms at the β-sites are also chemisorbed on the surface, indicating that the ligands are reacting with the base material. The energy required for reducing the adsorbed copper complex is 1.59eV, which is highly endothermic. Therefore, this copper precursor is not suitable for depositing copper by ALD on WN (111) surface.

The calculations show that this compound undergoes strong chemisorption on Cu (100) surface with adsorption energy of -2.11 eV. The energy required for reducing adsorbed copper precursor is -3.03eV. Therefore, this compound can be used to deposit copper on copper by ALD.

Since the whole copper ALD process requires depositing copper first on the barrier layer then depositing copper on copper that is already deposited on the barrier layer, this organometallic copper compound is not suitable for depositing copper by ALD on a barrier layer.

### Comparative Example 5

The first principles calculations were performed for Cu (II) precursor with structure E shown below. The structure consists of 2 6-membered rings with 4 oxygen atoms chelating the Cu atom.

### Structure E

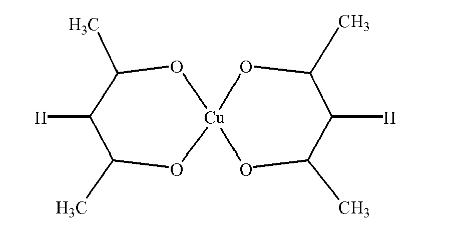

The calculations show that this molecule undergoes strong chemisorption on the surface of tungsten nitride barrier layer with (111) preferred orientation, i.e. WN (111). The adsorption energy is calculated to be -1.83eV. Besides the Cu atom, the carbon atoms at the β-sites are also chemisorbed on the surface. The calculated energy for the reduction step is 0.26eV, which is endothermic. Therefore, this copper precursor is not suitable for depositing copper by ALD on WN (111) surface.

The calculations show that this compound undergoes this compound also undergoes strong chemisorption on the Cu (100) surface with an adsorption energy of -2.25eV. The calculated energy for the reduction step is -3.17eV. Therefore, this compound can be used to deposit copper on copper by ALD.

Since the whole copper ALD process requires depositing copper first on the barrier layer then depositing copper on copper that is already deposited on the barrier layer, this organometallic copper compound is not suitable for depositing copper by ALD on a barrier layer.

### Example 6

The first principles calculations were performed for Cu (II) precursor with structure F shown below. The structure consists of 2 6-membered rings with 4 oxygen atoms chelating the Cu atom.

### Structure F

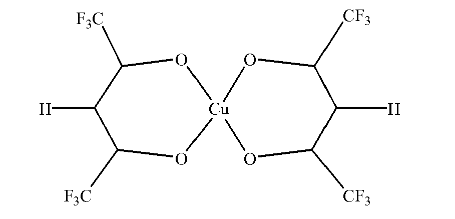

This is a new compound that has not been used by anyone tor depositing copper either by CVD or ALD.

The calculations show that this molecule undergoes strong chemisorption on the surface of tungsten nitride barrier layer with (111) preferred orientation, i.e. WN (111). The adsorption energy is calculated to be -0.38eV. The energy required for the reduction step is calculated to be -0.69eV, which is exothermic rather than endothermic. Therefore, this copper precursor is suitable for depositing copper by ALD on WN (111) surface.

The calculations show that this compound undergoes strong chemisorption on Cu (100) surface with adsorption energy of -2.41eV. The energy required for the reduction step is calculated to be -2.82eV. Therefore, this compound can be used to deposit copper on copper by ALD.

Since the whole copper ALD process requires depositing copper first on the barrier layer then depositing copper on copper that is already deposited on the barrier layer, this organometallic copper compound is suitable for depositing copper by ALD on a barrier layer.

All Cu (I) and Cu (II) precursors described in the foregoing Examples were found to be suitable for deposition of copper on copper. Therefore, the provision of a copper layer on a barrier layer by ALD is largely dependent on the success of depositing copper on the barrier layer. It was found that the adsorption of these precursors on the surface of barrier and copper layers was thermodynamically favorable. However, strong adsorption of the comparative precursors on the surface of the barrier layer made the reduction step highly endothermic, thereby shutting down the deposition process. It was unexpectedly found that ligands with electron-withdrawing groups, such as CF₃ groups, allowed the precursors to interact with the WN (111) surface only via the Cu atoms while the ligands were repelled from the N-rich surface as much as possible. Consequently, both adsorption and reduction steps were thermodynamically favorable for depositing copper on the barrier layer. In contrast, precursors without the strong electron withdrawing groups interacted with the substrate via both the Cu atoms and the ligands, leading to very stable adsorption structures on the surface. As a result of this, the reduction step became highly endothermic, making it difficult to reduce the precursor in the reduction step and deposit copper on copper.

## Claims

1. An organometallic precursor complex that will undergo exothermic chemisorption onto a fully passivated diffusion barrier layer and onto a metal layer deposited on a diffusion barrier layer, and that will undergo exothermic reduction when on the diffusion barrier layer or the metal layer and contacted with a reducing agent, wherein the complex comprises a metal of the metal layer and ligands containing electron withdrawing groups.

2. An organometallic precursor complex represented by Formula I: 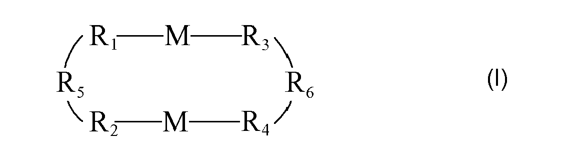 or Formula II: 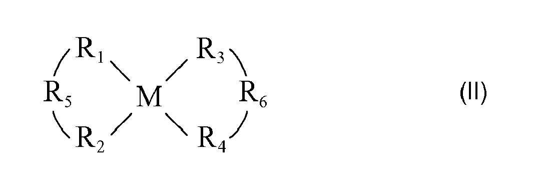 where M is Cu, Co, Ni, Ru, Au, Pd, Ag or Pt, each of R₅ and R₆ independently represents a C1 to C3 hydrocarbon and each of R₁, R₂, R₃ and R₄ independently represents an element selected from N, O, P, B and S, provided that at least one of R₁, R₂, R₃, R₄, R₅ and R₆ is independently substituted with at least one electron withdrawing group.

3. The complex of claim 2, wherein the complex is an organometallic copper complex represented by Formula III: 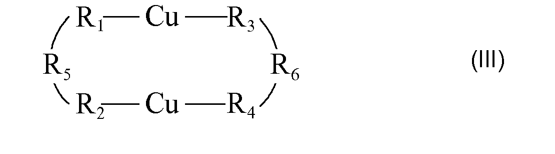 or Formula IV: 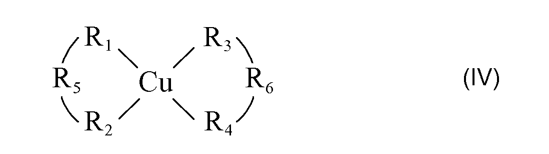 where each of R₅ and R₆ independently represents a C1 to C3 hydrocarbon and each of R₁, R₂, R₃ and R₄ independently represents an element selected from N, O, P, B and S, provided that at least one of R₁, R₂, R₃, R₄, R₅ and R₆ is independently substituted with at least one electron withdrawing group.

4. The complex of claim 2 or 3, wherein each of R₅ and R₆ is independently an unbranched alkyl group.

5. The complex of any one of claims 2 to 4, wherein the at least one electron withdrawing group is at least one member selected from -CF₃, -CN, -CHO, -NO₂, -COCF₃, -COF, -Aryl, -CH(CF₃)₂, -C(CF₃)₃ and -SO₂CF₃.

6. The complex of any one of claims 2 to 5, wherein each of R₅ and R₆, or wherein each of R₁, R₂, R₃, R₄, R₅ and R₆, is independently substituted with at least one electron withdrawing group.

7. The complex of claim 3, represented by the following structure:

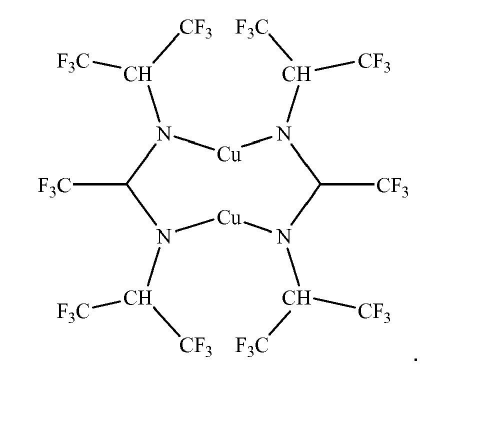

8. The complex of claim 3, represented by the following structure:

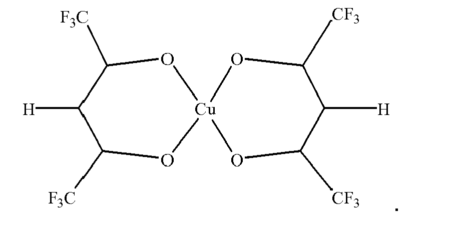

9. A process for providing a metal layer on a fully passivated diffusion barrier layer, said process comprising:
supplying the complex of any one of claims 1 to 8;
adsorbing the complex on the diffusion barrier layer ; and
reducing the complex on the diffusion barrier layer to provide the metal layer by atomic layer deposition on the diffusion barrier layer.

10. The process of claim 9, wherein the diffusion barrier layer comprises a metal nitride, a metal carbide, a metal carbonitride, a metal silicon nitride, a metal silicon carbide, a metal silicon carbonitride, or a mixture thereof.

11. The process of claim 10, wherein the diffusion barrier layer comprises a metal nitride selected from chromium nitride, tantalum nitride, titanium nitride, tungsten nitride, molybdenum nitride, zirconium nitride, vanadium nitride and mixtures thereof.

12. The process of any one of claims 9 to 11, wherein the supplying, adsorbing and reducing steps are repeated a plurality of times such that the depth of the metal layer is increased.

13. The process of any one of claims9 to 12, wherein the diffusion barrier layer comprises substantially pure tungsten nitride with (111) preferred orientation, the adsorbing step comprises chemisorption of the complex on the tungsten nitride (111) or on the metal deposited on the tungsten nitride (111), and the reducing step comprises reduction of the complex on the tungsten nitride (111) or on the metal deposited on the tungsten nitride (111).

14. The process of any one of claims 9 to 13, wherein: (a) the process is conducted in an atomic layer deposition chamber; and (b) the supplying step comprises providing the complex in the atomic layer deposition chamber in a vapor phase.

15. A substrate comprising a metal layer produced by the process of any one of claims 9 to 14.
